(19) Europäisches Patentamt
European Patent Office
Office européen des brevets

(11) Publication number: 0 546 696 A1

# EUROPEAN PATENT APPLICATION

(21) Application number: 92310456.6

(22) Date of filing: 16.11.92

(51) Int. Cl.⁵: G03F 7/38, G03F 7/00, H01L 41/26

(30) Priority: 13.12.91 US 806501

(43) Date of publication of application:
16.06.93 Bulletin 93/24

(84) Designated Contracting States:
DE FR GB

(71) Applicant: Hewlett-Packard Company
3000 Hanover Street
Palo Alto, California 94304(US)

(72) Inventor: Lum, Paul
690 Templebar Way
Los Altos, California 94022(US)
Inventor: Kendle, Belinda J.
21746 Noonan Court
Cupertino, California 95014(US)
Inventor: Greenstein, Michael
860 Covingston Road
Los Altos, California 94024(US)

(74) Representative: Williams, John Francis et al
WILLIAMS, POWELL & ASSOCIATES 34
Tavistock Street
London WC2E 7PB (GB)

(54) Process for lithography on piezoelectric films.

(57) In a process for producing a selected metal or other pattern having linewidths no more than 25 $\mu$m on a thin film (11) of piezoelectric material, such as poly vinylidene fluoride or poly(vinylidene fluoride-trifluoroethylene) or PZT, a positive photoresist coating (43) is applied to a selected surface of the film and is irradiated and developed to produce the selected pattern. A first metal coating to adhere to the film surface and a second thicker metal are deposited to define the selected pattern. A chlorobenzene solution may be used to decrease the development rate and to facilitate liftoff of the remaining photoresist material. This process may also be applied to produce multiple layer patterns with electrical interconnects on one or more surfaces of a film of piezoelectric material.

This invention relates to lithography of small line width patterns on piezoelectric thin film materials.

Lithographic patterning on standard piezoelectric materials, such as PZT and other ceramics, has been widely developed over the last 15 years. As a result of such developments, patterns with linewidths of the order of 100 $\mu$m and larger can be laid down using well known techniques, and such techniques can be applied to most materials that are known to be piezoelectric ("PZ"). However, such techniques usually require indirect deposit of a pattern or of circuit lines on the PZ material, working with an intermediate material that accepts the pattern and is then deposited on a surface of the PZ material. This technique does not permit pattern linewidths much smaller than 100 $\mu$m to be deposited, in part, because such a pattern becomes delicate and subject to disintegration if the pattern linewidth is made smaller.

What is needed is a process that allows pattern linewidths as small as 10 $\mu$m to be formed on PZ materials. Preferably, the process should allow these patterns to be formed on two opposing sides of a PZ material, for example, on two surfaces of a film of the PZ material.

These needs are met by a method that, in one embodiment, uses specially chosen PZ materials such as poly vinylidene fluoride ("PVDF") films as a base for such patterns. A thin film of PVDF, of thickness in the approximate range 30-100 $\mu$m, is stretched and coated on one (planar) surface with a thin coating of positive photoresist material, such as Hoechst AZ-1350, of thickness in the approximate range 1.5 - 3 $\mu$m, that has been softbaked at a temperature T = 70-100°C for 60-120 sec. The PVDF film is then exposed to electromagnetic radiation having the predetermined pattern for a time interval of length in the range 5 - 60 seconds, where the selected pattern has line widths no larger than 25 $\mu$m and may have line widths as small as 10 $\mu$m. The selected pattern is then developed at a temperature T ≈ 25°C, using a developer such as KOH-based solution at controlled humidity to expose a portion of the PVDF film in the selected pattern. A thin coating, of thickness in the approximate range 200-400 Å, of a first selected adhesion metal, such as Cr, Ti or Ni, is deposited on the exposed portion of the PVDF film to bind to the PVDF film and to provide a suitable substrate for another metal that will provide the bulk of the metallized pattern. A thin coating, of thickness in the range 2,000 - 4,000 Å, of a second selected metal, such as Au or Ag, is then deposited over the first metal coating to provide the selected pattern on the PVDF piezoelectric material. The remaining photoresist material is then removed or lifted off, using an acetone or butyl acetate bath at a temperature in the approximate range T ≈ 25°C plus a sonicator. Optionally, the PVDF and photoresist material can be bathed in a chlorobenzene solution before the development step to reduce the rate of photoresist development and improve the shape of walls adjacent to the developed and removed photoresist material after development. Another suitable PZ material for patterning according to the invention is poly-(vinylidene fluoride-trifluoroethylene)("P(VDF-TrFE)").

In a second embodiment, separate patterns on a front surface and a back surface of the PVDF or P-(VDF-TrFE) film may be laid down, Using a similar process for pattern deposit on each surface. Each surface is suitably protected when a pattern is being deposited on the other surface.

Figure 1 is a schematic view illustrating fixturing of a PVDF film.

Figure 2 is a flow chart illustrating the general process for patterning of one side of a PZ substrate according to the invention.

Figures 3A and 3B are schematic views illustrating the effect on exposed photoresist material adjacent to unexposed photoresist material where a chlorobenzene soak of the photoresist material (A) is used and (B) is not used.

Figure 4 is a flow chart illustrating the general process for patterning of two sides of a PZ substrate according to the invention.

Figure 5 is a flow chart illustrating multi-layer patterning according to the invention.

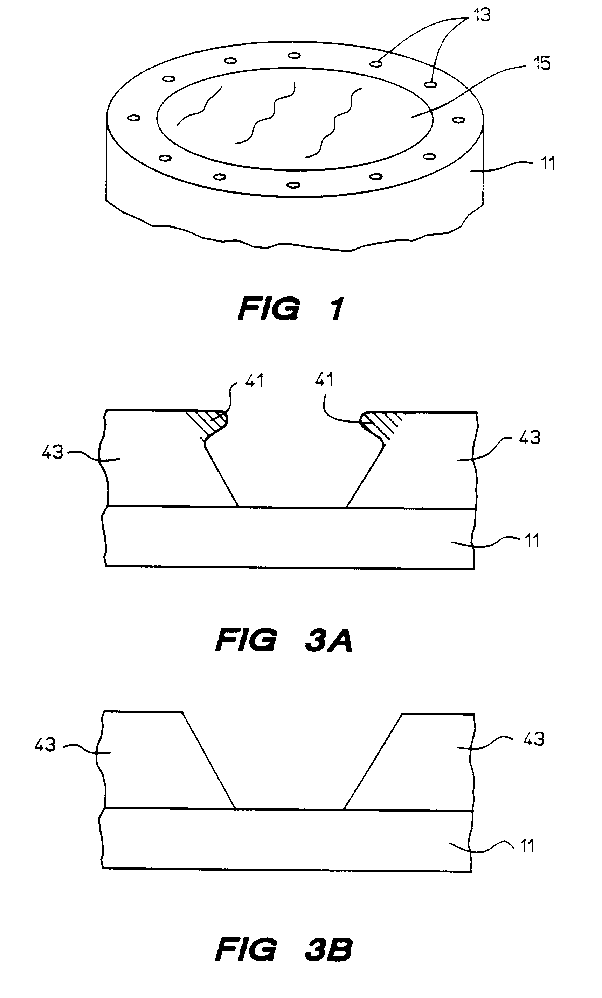

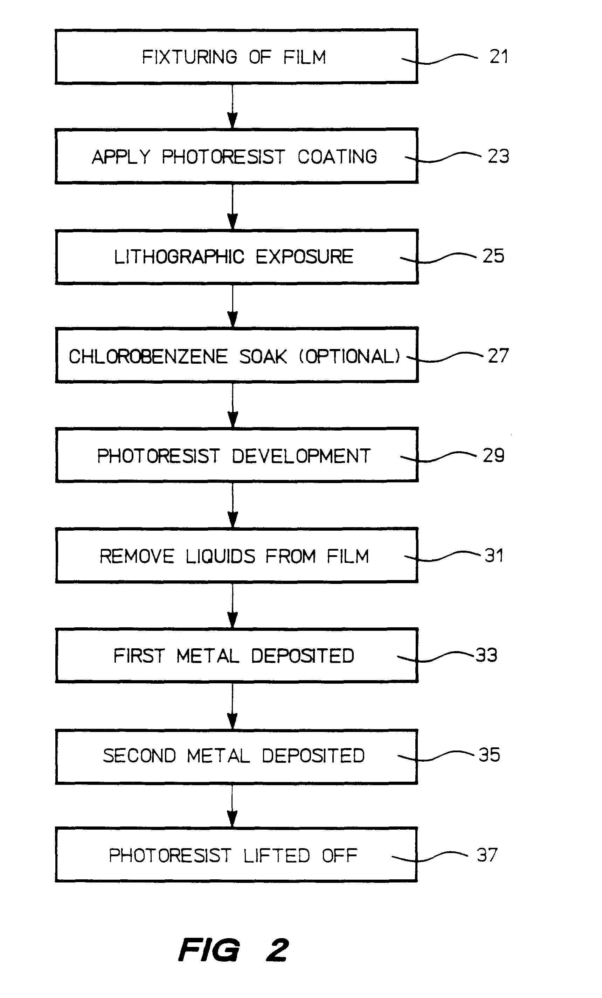

Figure 1 illustrates fixturing that is applied to the PVDF film to provide a surface that is approximately planar and free from wrinkles. A PVDF film 11 is held in a ring fixture 13 and stretched, preferably in two dimensions, to produce an approximately planar film surface 15 for deposit of the selected pattern thereon. The two-dimensional strain need only be a few percent to provide a planar surface adequate for photolithography.

Figure 2 illustrates, in flow chart form, a sequence of steps performed according to the invention, where a single selected surface or side of the PVDF film is to be patterned. The PVDF film preferably has a thickness of 30-100 $\mu$m after stretching. After the PVDF film is fixtured and stretched, in step 21, a positive photoresist ("pr") material, such as Hoechst AZ-1350 of thickness 1.5 - 3 $\mu$m, is applied to the selected surface, in step 23.

The pr material is then irradiated, in step 25, to define the selected pattern, using either (1) contact proximity and a contact mask with a light source, such as a 250 Watt source, or (2) ultraviolet direct write (no mask) at a wavelength such as $\lambda$ = 365 Å from a 500 Watt uv light source. The total radiation time may be $\Delta t$ = 10-120 sec, with 20 sec being a representative time, and irradiation to produce the selected

2

pattern preferably occurs by rastering, with a pixel area of about 2 $\mu m^2$.

At this point, the PVDF film and exposed pr material may optionally be soaked in chlorobenzene for a time interval such as $\Delta t$ = 12 minutes at a temperature T = 20-30°C, as indicated in step 27. Chlorobenzene will diffuse through the pr material, interact with the exposed portion of this material and interfere with removal of the exposed material by the development step. Use of chlorobenzene for such purposes is discussed by M. Hatzakis et al, IBM Jour. Res. Develop., vol. 24 (1980) pp. 452-460, by R.M. Halverson et al, IBM Jour. Res. Develop., vol. 26 (1982) pp. 590-595, and by G.G. Collins and C.W. Halstead, IBM Jour. Res. Develop., vol. 26 (1982) pp. 596-604. If optional step 27 is performed, edges of the exposed pr material that are adjacent to unexposed pr material form a "lip" area that will not be removed in the subsequent development step. An example of this action of the chlorobenzene is illustrated in Figure 3A, in which a lip 41 of exposed pr material that is adjacent to unexposed pr material 43 is created using a chlorobenzene soak. Without the chlorobenzene soak applied the lip 41 would not be present, as indicated in Figure 3B, and certain line details of the metal pattern would not appear on the exposed portion of the PVDF film. However, use of the chlorobenzene is optional here. Optionally, excess chlorobenzene is blown off by an inert gas, such as $N_2$, before subsequent steps are performed.

In step 29 of Figure 2, the exposed pr material is then developed using Shipley's KOH-based developer solution or another suitable developer at a temperature T = 25°C for a time interval $\Delta t$ = 60-120 sec to remove the exposed portion of the pr material. Removal of portions of the pr material exposes underlying portions of the PVDF film. The developed structure is then rinsed in deionized water and blown dry using $N_2$ gas for a time interval $\Delta t$ = 60-180 sec to remove all liquids present in step 31.

In step 33, a first thin adhesion layer of metal, such as Cr, Ti or Ni, of thickness $h_1$ = 200-400 Å, is deposited on the exposed portion of the PVDF film to adhere tightly to the PVDF film and to form a base to which a second metal can adhere. In step 35, a second thin layer of metal of higher electrical conductivity, such as Au at a thickness of $h_2$ = 2,000-4,000 Å, is deposited over and adheres to the first layer of metal. If the second, higher conductivity metal were deposited directly on the exposed portion of the PVDF film, this metal would not properly adhere to the PVDF film.

In step 37, the remaining pr material is removed using an acetone bath at room temperature for a time interval $\Delta t$ = 60-180 sec plus application of a sonicator to the structure. Step 37 facilitates the lift-off of the remaining unexposed pr material to expose the PVDF film. Only the previously exposed and developed portions covered with deposited metal adhering to the PVDF film, are allowed to remain on the PVDF film surface. This completes the procedure for deposit of a selected metal pattern on a single side or surface of the PVDF film.

If a second selected surface of the PVDF film is also to be given a selected pattern of metal, the first, already-patterned surface of the film is protected by polyimide or pr material before the second surface pattern is formed. The second surface has some fiducial marks to facilitate optical alignment of the pattern on the second surface relative to the pattern already deposited on the first surface. The second surface is cleaned using suitable solvents, and the first, already-patterned surface is protected by deposit of a coating of polyimide or pr material thereon. This protective coating is then removed, using an acetone or butyl acetate bath, after the second selected pattern is deposited on the second surface.

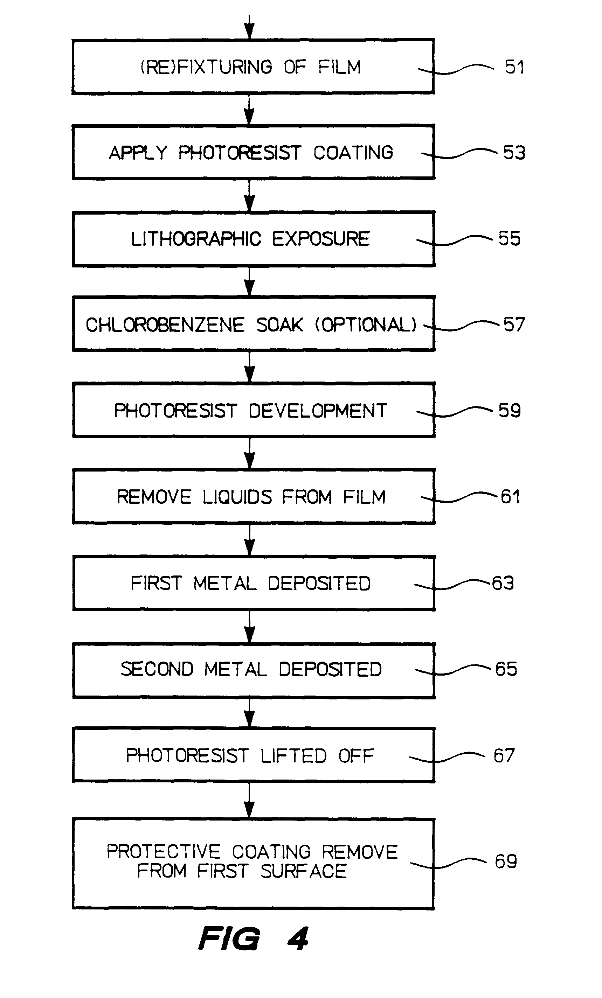

The process for deposit of metal in a second selected pattern is illustrated in the flow chart in Figure 4, where the steps 51, 53, 55, 57, 59, 61, 63, 65 and 67 are analogous to the respective steps 21, 23, 25, 27, 29, 31, 33, 35 and 37 performed for the first selected pattern. Preferably, irradiation of the pr material on the surface of the PVDF film should be done without first passing the radiation beam through the PVDF film, to avoid defocusing of this beam before the beam passes through the targeted pr material on the PVDF film surface. One method of achieving this utilizes the first deposited metal layer (Cr, Ti or Ni) as a focusing plane on the surface of interest. This first metal layer (Cr, Ti or Ni) can be subsequently patterned, using the second metal layer (Au or Ag). This approach can be applied to both surfaces of the PVDF film. In step 69 of this process, the protective pr coating on the first, already-patterned surface is removed after the pattern on the second surface has been formed.

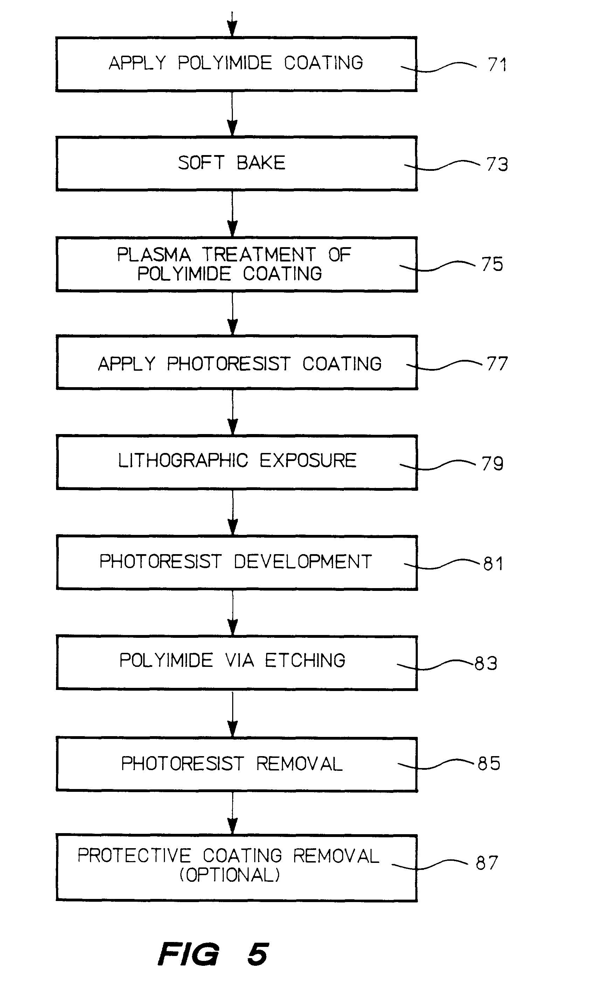

Application of additional metal layers with interlayer dielectrics as a multi-layer interconnect process is illustrated by an extension of the above-described process, after step 37 or step 69, to include spin-on deposition of a polyimide layer, such as Amoco 1414, of thickness of 0.5-2 $\mu m$, the thickness depending upon the dielectric protection requirements. As illustrated in the flow diagram of Figure 5, this polyimide is then softbaked at a temperature T ≈ 120°C for $\Delta t$ ≈ 200 sec. An interconnect via patterning layer of pr is then spun on over the polyimide after an oxygen plasma treatment is carried out (60 sec at 100 Watts, using 100 percent $O_2$ at a pressure of 150 millitorr). After the pr material has been softbaked at a temperature T ≈ 100°C, a via contact hole pattern, aligned to the preceding layer pattern, is deposited and exposed. Exposed pr material is developed, and via contact holes are opened in the underlying polyimide layer with an n-butanol-based solvent by either spray or immersion etching. The remaining pr material is then stripped from the polyimide, using a dilute solution of n-butyl acetate-based solvent. The interconnect metal is then deposited to electrically connect the layers, as described above.

The piezoelectric film material poly vinylidene fluoride (PVDF) has many desirable features. First, the film is polymeric and thus less brittle than films of other piezoelectric materials such as lithium niobate and lithium tantalate. Second, the film has a modest, but workable, thickness mode coupling coefficient $k_t = 0.1$ - 0.2, as discussed by Sherar and Foster in Ultrasonic Imaging, vol. 11 (1989) pp. 75-94. Third, PVDF film is not strongly sensitive to the chemicals used to perform photoresist patterning on a surface thereof. The film material is a semicrystalline polymer, consisting of lamellar crystals of around 2,000 repeat units of $CH_2CF_2$ embedded in an amorphous matrix. The relative dielectric permittivity coefficient $\epsilon_r$ varies from about 8.5 down to 4.5 as the applied frequency is increased from 0 to 250 MHz, and the dielectric loss tangent varies from 0.24 to 0.26 for frequencies in this range. The sound speed in PVDF material has been measured at around 2250 meters/ sec and around 2500 meters/ sec by various workers. The acoustic impedance for the film material is around $4.5 \times 10^6$ Rayls, which is about three times the acoustic impedance of water.

Another attractive piezoelectric material, PVDF-copolymerized with trifluoroethylene ("P(VDF-TrFE)"), has been reported by Ohigashi et al, Ferroelectrics 1984, Gordon & Breach, vol. 60, 1984, pp. 263-276. Ohigashi et al find that P(VDF-TrFE) has a higher coupling coefficient $k_t$ than PVDF, if the molecular weight percent of vinylidene fluoride present is around 55 percent or greater than about 80 percent. Table 1 summarizes some data reported by Ohigashi et al for PVDF, P(VDF-TrFE) and PZT-4®, which is a piezoelectric material marketed by Vernitron that contains lead oxide, zirconium oxide and titanium oxide, that can also be deposited in situ in thin films.

Table 1

| Parameter | PVDF | P(VDF-TrFE) | PZT-4® |
|---|---|---|---|
| Density (gm/cm³) | 1.78 | 1.88 | 7.5 |
| Acoustic vel (km/sec) | 2.26 | 2.40 | 4.60 |
| Acoustic imped ($10^6$ kgm/m²-sec) | 4.20 | 4.51 | 34.8 |
| Relative dielectric coefficient | 6.2 | 6.0 | 635 |
| Coupling coeff $k_t$ | 0.20 | 0.30 | 0.51 |
| $d_{31}$ (pC/N) | 25.0 | 12.0 | -123 |

Either PVDF or P(VDF-TrFE), or any other polymeric piezoelectric or ceramic piezoelectric thin film material with coupling coefficient $k_t \geq 0.1$, may be a suitable material for use in this invention.

Daniel H. Turnbull, in his 1991 Ph.D. Thesis, "Two-dimensional Transducer Arrays For Medical Ultrasound Imaging", submitted to the University of Toronto, Department of Medical Biophysics, briefly discusses the work of the inventors of the invention disclosed here (Thesis, pp. 131-134) and notes that some fringe electrical field problems are present in other configurations of PVDF studied by other workers for other purposes. We have not encountered these fringe electrical field problems with the approach used in our invention.

**Claims**

1. A method of forming a selected pattern of lines of linewidth no more than 25 $\mu$m on a surface of a piezoelectric material, the method being characterised by the steps of:

(1) providing a thin film (11) of piezoelectric material having a coupling coefficient $k_t$ of $\geq 0.1$, of thickness in the range 30-100 $\mu$m;

(2) applying a thin coating of positive photoresist material (43), of thickness in the range 1.5-3 $\mu$m, to a selected surface of the film (11);

(3) exposing the film (11) to electromagnetic radiation, having a predetermined wavelength range and having the selected pattern, for a time interval of length in the range 5-60 sec, where the selected pattern has linewidths no more than 25 $\mu$m;

(4) developing the film (11) with the irradiated photoresist material coating thereon to expose a portion of the selected surface of the film in the selected pattern;

(5) applying a thin coating of a first selected metal of a predetermined first metal thickness over the exposed portion of the film to adhere to, and to form a replica of the selected pattern on, the selected surface of the film;

(6) applying a thin coating of a second selected metal of a predetermined second metal thickness over the selected pattern of the first selected metal; and

(7) removing the remainder of the photoresist material (43)so that metal having the selected pattern remains and adheres to the selected surface of the film (11).

2. The method of claim 1, further characterised by the step of applying a liquid solution of chlorobenzene at a temperature in the range T = 20-30°C to said film after said step (3) and before said step (4) and allowing the chlorobenzene solution to diffuse into and through said portions of said photoresist material (43) that were exposed to said radiation in said selected pattern in order to decrease the time rate of said development in said step (4).

3. The method of claim 1 or 2, wherein said step of exposing said film (11) to radiation is further characterised by the step of irradiating said photoresist material (43) in said selected pattern by direct writing of said selected pattern on said photoresist material with an electromagnetic beam having wavelengths below $\lambda = 4,000$ Å for a predetermined time interval.

4. The method of claim 1 or 2, wherein said step of exposing film (11) to radiation is further characterised by the steps of irradiating said photoresist material (43) in said selected pattern by (i) providing a radiation mask that is opaque to said radiation except where said selected pattern occurs and that is positioned between said radiation and said photoresist material and adjacent to said photoresist material and (ii) irradiating the mask and said photoresist material with said electromagnetic radiation for a predetermined time interval.

5. The method of any preceding claim, further characterised by the steps of selecting said first selected metal from the group consisting of chromium, titanium and nickel and selecting said predetermined first metal thickness in the range 200-400 Å.

6. The method of any preceding claim, further characterised by the steps of selecting said second selected metal from the group consisting of gold and silver and selecting said predetermined second metal thickness in the range 2,000-4,000 Å.

7. The method of any preceding claim, further characterised by the step of choosing said selected pattern to have linewidths no more than 10 $\mu$m.

8. The method of any preceding claim, further characterised by the step of choosing said piezoelectric material from the class of piezoelectric materials consisting of polyvinylidene fluoride and poly-(vinylidene fluoride-trifluoroethylene).

9. The method of claim 1, further characterised by the step of choosing as said piezoelectric material a compound of containing lead oxide, zirconium oxide and titanium oxide and known as PZT, deposited in situ.

10. A method of forming at least first and second selected pattern of lines, each pattern having linewidth no more than 25 $\mu$m, on a piezoelectric material, the method being characterised by the steps of:

(1) providing a thin film of piezoeletric material (11) having a coupling coefficient $k_t \geq 0.1$, of thickness in the range 30-100 $\mu$m;

(2) applying a first thin coating of positive photoresist material (43), of thickness in the range 1.5-3 $\mu$m, to a selected surface of the film;

(3) exposing the selected surface of the film (11) and the first coating of photoresist material to electromagnetic radiation, having a predetermined wavelength range and having the selected pattern, for a time interval of length in the range 5-60 sec, where the first selected pattern has linewidths no more than 25 $\mu$m;

(4) developing the film (11) with the irradiated first coating of photoresist material thereon to expose a portion of the selected surface of the film in the first selected pattern;

(5) applying a thin coating of a first selected metal of a predetermined first metal thickness over the exposed portion of the film (110) to adhere to, and to form a replica of the first selected pattern on, the first selected surface of the film;

(6) applying a thin coating of a second selected metal of a predetermined second metal thickness over the first selected pattern of the first selected metal;

(7) removing the remainder of the first photoresist coating so that metal having the first selected pattern remains and adheres to the first selected surface of the film (11);

(8) providing a protective layer of insulating material over the selected surface of the film (11) at a temperature no higher than 120°C; and

(9) applying steps (2) - (7) to an exposed surface of the protective layer to define a second selected pattern thereon.

FIG 1

FIG 3A

FIG 3B

```
┌─────────────────────────────────────┐
│         FIXTURING OF FILM            │──── 21
└─────────────────────────────────────┘
                   │
                   ▼
┌─────────────────────────────────────┐
│       APPLY PHOTORESIST COATING      │──── 23
└─────────────────────────────────────┘
                   │
                   ▼
┌─────────────────────────────────────┐
│        LITHOGRAPHIC EXPOSURE         │──── 25
└─────────────────────────────────────┘
                   │
                   ▼
┌─────────────────────────────────────┐
│    CHLOROBENZENE SOAK (OPTIONAL)     │──── 27
└─────────────────────────────────────┘
                   │
                   ▼
┌─────────────────────────────────────┐
│       PHOTORESIST DEVELOPMENT        │──── 29
└─────────────────────────────────────┘
                   │
                   ▼
┌─────────────────────────────────────┐
│       REMOVE LIQUIDS FROM FILM       │──── 31
└─────────────────────────────────────┘
                   │
                   ▼
┌─────────────────────────────────────┐
│        FIRST METAL DEPOSITED         │──── 33
└─────────────────────────────────────┘
                   │
                   ▼
┌─────────────────────────────────────┐
│        SECOND METAL DEPOSITED        │──── 35
└─────────────────────────────────────┘
                   │
                   ▼
┌─────────────────────────────────────┐
│       PHOTORESIST LIFTED OFF         │──── 37
└─────────────────────────────────────┘
```

**FIG 2**

**FIG 4**

Flowchart:

- (RE)FIXTURING OF FILM — 51
- APPLY PHOTORESIST COATING — 53
- LITHOGRAPHIC EXPOSURE — 55
- CHLOROBENZENE SOAK (OPTIONAL) — 57
- PHOTORESIST DEVELOPMENT — 59
- REMOVE LIQUIDS FROM FILM — 61
- FIRST METAL DEPOSITED — 63
- SECOND METAL DEPOSITED — 65
- PHOTORESIST LIFTED OFF — 67
- PROTECTIVE COATING REMOVE FROM FIRST SURFACE — 69

```
        ┌─────────────────────────────────┐
        │     APPLY POLYIMIDE COATING      │───── 71
        └─────────────────────────────────┘
                        │
                        ▼
        ┌─────────────────────────────────┐
        │            SOFT BAKE             │───── 73
        └─────────────────────────────────┘
                        │
                        ▼
        ┌─────────────────────────────────┐
        │       PLASMA TREATMENT OF        │───── 75
        │       POLYIMIDE COATING          │
        └─────────────────────────────────┘
                        │
                        ▼
        ┌─────────────────────────────────┐
        │     APPLY PHOTORESIST COATING    │───── 77
        └─────────────────────────────────┘
                        │
                        ▼
        ┌─────────────────────────────────┐
        │      LITHOGRAPHIC EXPOSURE       │───── 79
        └─────────────────────────────────┘
                        │
                        ▼
        ┌─────────────────────────────────┐
        │     PHOTORESIST DEVELOPMENT      │───── 81
        └─────────────────────────────────┘
                        │
                        ▼
        ┌─────────────────────────────────┐
        │      POLYIMIDE VIA ETCHING       │───── 83
        └─────────────────────────────────┘
                        │
                        ▼
        ┌─────────────────────────────────┐
        │       PHOTORESIST REMOVAL        │───── 85
        └─────────────────────────────────┘
                        │
                        ▼
        ┌─────────────────────────────────┐
        │   PROTECTIVE COATING REMOVAL     │───── 87
        │          (OPTIONAL)              │
        └─────────────────────────────────┘
```

FIG 5

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| Y | DD-A-221 292 (INGENIEURHOCHSCHULE DRESDEN) * the whole document * | 1-10 | G03F7/38 G03F7/00 H01L41/26 |
| D,Y | IBM JOURNAL OF RESEARCH AND DEVELOPMENT vol. 24, no. 4, July 1980, NEW YORK US pages 452 - 460 M. HATZAKIS ET AL. 'Single-Step Optical Lift-Off Process' | 1-10 | |
| Y | PATENT ABSTRACTS OF JAPAN vol. 011, no. 171 (E-512)6 February 1987 & JP-A-62 006 509 ( MATSUSHITA ) 13 January  1987 * abstract * | 1-10 | |
| Y | JOURNAL OF APPLIED PHYSICS vol. 61, no. 10, 15 May 1987, NEW YORK US pages 4749 - 4754 K. KIMURA ET AL. 'Generation of Very High-Frequency Ultrasonic Waves Using Thin Films of Vinylidene Fluoride-Trifluoroethylene Copolymer' | 1-10 | |
| A | EP-A-0 112 509 (EUROSIL ELECTRONIC) | | TECHNICAL FIELDS SEARCHED (Int. Cl.5 ) G03F H01L |
| A | EP-A-0 217 064 (SIEMENS AG) | | |

The present search report has been drawn up for all claims

| Place of search | Date of completion of the search | Examiner |
|---|---|---|
| THE HAGUE | 19 JANUARY 1993 | HAENISCH U.P. |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

    .....................................................................................................

& : member of the same patent family, corresponding
    document

EPO FORM 1503 03.82 (P0401)